# EUROPÄISCHE PATENTSCHRIFT

(11) **EP 2 963 808 B1**
(45) Veröffentlichungstag und Bekanntmachung des Hinweises auf die Patenterteilung: **16.08.2017**
(21) Anmeldenummer: 15170119.0
(22) Anmeldetag: 01.06.2015
(51) Int. Cl.: H02P 29/02, G01R 31/34, G05B 23/02

(54) **VERFAHREN UND SCHUTZGERÄT ZUM SCHUTZ EINES ELEKTROMOTORS UND/ODER EINER DAMIT GEKOPPELTEN ARBEITSMASCHINE VOR FEHLANSTEUERUNGEN**
METHOD AND SAFETY DEVICE FOR PROTECTING AN ELECTRIC MOTOR AND/OR A WORK DEVICE COUPLED TO IT AGAINST MALFUNCTION
PROCÉDÉ ET APPAREIL DE PROTECTION D'UN MOTEUR ÉLECTRIQUE ET/OU D'UNE MACHINE DE TRAVAIL Y ÉTANT COUPLÉE AVANT DYSFONCTIONNEMENT

(30) Priorität: 02.07.2014 DE 102014109279
(43) Veröffentlichungstag der Anmeldung: 06.01.2016
(73) Patentinhaber: KRIWAN INDUSTRIE-ELEKTRONIK GMBH, 74670 Forchtenberg (DE)
(72) Erfinder: Ellwein, Christian, Dr., 74523 Schwäbisch Hall (DE)
(74) Vertreter: Tetzner, Michael

(56) Entgegenhaltungen:
- EP-A2- 1 227 377
- DE-A1-102008 004 219
- US-A1- 2009 079 380

## Beschreibung

Die Erfindung betrifft ein Verfahren und ein Schutzgerät zum Schutz eines Elektromotors und/oder einer damit gekoppelten Arbeitsmaschine vor Fehlansteuerungen.

Elektromotoren werden in vielen Anwendungen eingesetzt, teilweise auch in Applikationen mit kritischer Infrastruktur, wie beispielsweise bei Pumpen der Wasserversorgung oder bei Kühlprozessen in Kraftwerken. In der immer stärker durch Netzwerktechnik, Computer und IT vernetzten Welt, können auch industrielle Anwendungen Angriffen von Hackern, Viren und Schadsoftware ausgesetzt sein. Dieses Problem wird in den vergangenen Jahren insbesondere dadurch verschärft, dass zunehmend proprietäre oder isolierte Feldbusse und Steuerungs- und Leitsysteme durch TCP/IP basierte Netzwerke (Industrial Ethernet) ersetzt und ergänzt werden. In vielen Fällen haben dadurch Steuerungen, Regler, Frequenzumrichter und andere Ansteuereinheiten für Elektromotoren eine Verbindung zum Internet. Diese Steuer- und Regeleinrichtungen zur Ansteuerung von Elektromotoren sind heute nahezu vollständig Mikroprozessor basiert, wobei häufig Linux als Betriebssystem verwendet wird, und haben frei programmierbare Speicher und sind somit technisch angreifbar für Schadsoftware. Ein weithin bekanntes Beispiel ist sie Schadsoftware "Stuxnet", mit der Zentrifugen im Iran mechanisch beschädigt wurden.

Es ist bekannt, dass der Schutz vor Schadsoftware nie 100% sein kann. Immer wieder werden durch neu entdeckte Sicherheitslücken in Standardprogrammen neue Probleme entstehen. Es ist davon auszugehen, dass auch bei der Vernetzung von Maschinen und Anlagen eine ähnliche Problematik auftritt, indem potentiell kritische Schadsoftware auf einer SPS, einem Frequenzumrichter oder einem Regler eingespielt wird, die von der jeweils aktuellen Schutzsoftware noch nicht erkannt wird.

Im Office-Bereich beschränkt sich der Schutzbedarf im Wesentlichen auf Daten, wobei die Integrität, die Vertraulichkeit und die Verfügbarkeit der Daten sichergestellt werden soll. Im Schadensfall besteht in den meisten Fällen die Möglichkeit, durch eine Neuinstallation des Systems und eine Rekonstruktion der Daten aus einem Backup einen wesentlichen Teil des Schadens zu begrenzen. Im ICS - Bereich (Industrial Control Systems) ist das anders: hier können Maschinen durch Schadsoftware teilweise irreparabel beschädigt werden. Das hat zum einen die Folge, dass die betroffene Komponente ausgetauscht werden muss und zum anderen der durch die Komponente beeinflusste Prozess im hohen Maße gestört wird. Besonders kritisch sind hier Elektromotoren, die in sehr vielen Komponenten eingesetzt werden und durch eine falsche Ansteuerung beschädigt werden können. Auch die mit dem Elektromotor gekoppelten Arbeitsmaschinen, wie Pumpen, Verdichter oder Zugangssysteme (Tore, Türen, Rampen), sind entsprechend gefährdet. Elektromotoren werden schon heute durch Motorschutzrelais und Motorschutzschalter geschützt. Dazu werden als wesentliche Parameter die elektrische Stromaufnahme des Motors und/oder die Wicklungstemperatur gemessen und mit Grenzwerten verglichen (EP 1 967 831 B1).

Die DE 34 43 276 A1 betrifft eine Einrichtung und ein Verfahren zum Schützen von Motoren und zum Vorhersagen der Motorlebensdauer unter Verwendung der Temperatur und der vergangenen Betriebszeit des Motors. Dabei sind mit dem Motor verbundene Modelleinrichtungen zum Überwachen der Temperatur der Motorwicklungen und zum Erzeugen einer Fehlerrate für den Motor in Abhängigkeit von der Temperatur seiner Wicklungen vorgesehen. Die Fehlerrate wird von einem Integrator integriert, um einen Fehlerauftritt für den Motor zu erzeugen, wobei eine mit dem Integrator verbundene logische Auslöse- bzw. Schnellabschaltschaltung den Fehlerauftritt empfängt und in Abhängigkeit davon ein Auslöse- bzw. Abschaltsignal erzeugt.

Aus der US 2009/0079380 A1 ist ein Motorsteuerungssystem bekannt, das einen Inkrementalgeber zur Erfassung der Motorposition verwendet. Der Inkrementalgeber stellt einen 2-Bit-Code bereit, wobei es als ein Fehler angesehen wird, wenn sich beide Bits des 2-Bit-Codes verändern. Der Motor wird angehalten, wenn die Summe der Fehler einen vorgegebenen Wert überschreitet.

Die DE 10 2008 004 219 A1 beschreibt ein Verfahren zum Behandeln mindestens eines Fehlers innerhalb eines Systems, das eine Anzahl von Einheiten aufweist. Die Reihenfolge, nach der die Einheiten nacheinander auf Fehler überprüft werden, wird so ausgewählt, dass die Summe der Kosten zur Behandlung möglicher Fehler gewichtet mit den Auftretungswahrscheinlichkeiten der Fehler minimal ist.

Der Erfindung lag nun die Aufgabe zu Grunde, ein Verfahren und ein Schutzgerät zum Schutz eines Elektromotors und/oder einer damit gekoppelten Arbeitsmaschine vor Fehlsteuerungen anzugeben, das sich durch eine hohe Effizienz auszeichnet und einen wirkungsvollen Schutz des Elektromotors und/oder der damit gekoppelten Arbeitsmaschine gewährleistet.

Erfahrungsgemäß wird diese Aufgabe durch die Merkmale der Ansprüche 1 und 5 gelöst. Vorteilhafte Ausgestaltungen der Erfindung sind Gegenstand der weiteren Ansprüche.

Bei erfindungsgemäßen Verfahren zum Schutz eines Elektromotors und/oder einer damit gekoppelten Arbeitsmaschine vor Fehlansteuerungen wird die Anzahl von Fehlansteuerungen des Elektromotors und/oder der Arbeitsmaschine gemäß einem ersten Fehlerkriterium und die Anzahl von Fehlansteuerungen des Elektromotors und/oder der Arbeitsmaschine gemäß einem zweiten Fehlerkriterium erfasst und aufsummiert. Dabei wird ein Alarmsignal erzeugt und/oder der Elektromotor in einen vordefinierten Zustand geschaltet, wenn die Summe der erfassten Fehlansteuerungen ein vorgegebenes Limit überschreitet, wobei die Fehlerkriterien bei der Aufsummierung der Fehlansteuerungen unterschiedlich gewichtet werden.

Das erfindungsgemäße Schutzgerät zum Schutz eines Elektromotors und/oder einer damit gekoppelten Arbeitsmaschine vor Fehlansteuerungen sieht im Wesentlichen folgende Bauteile vor: eine erste Erfassungseinheit für Fehlansteuerungen des Elektromotors und/oder der Arbeitsmaschine gemäß einem ersten Fehlerkriterium, wenigstens eine zweite Erfassungseinheit für Fehlansteuerungen des Elektromotors und/oder der Arbeitsmaschine gemäß einem zweiten Fehlerkriterium, ein Summierglied zum Aufsummieren der Anzahl der Fehlansteuerungen mit unterschiedlicher Gewichtung der Fehlerkriterien und eine Auslöseeinheit zur Erzeugung eines Alarmsignals und/oder zum Schalten des Elektromotors in einen vordefinierten Zustand, wenn die Summe der erfassten Fehlansteuerungen ein vorgegebenes Limit überschreitet.

Die hier vorgestellte Erfindung beschreibt nun ein Motorschutzsystem, das über den Stand der Technik hinaus weitere physikalische Parameter misst, um eine kritische Ansteuerung des Motors zu erkennen. Da Elektromotoren von der Physik her sehr gut verstanden sind und die Arbeitsweise von herkömmlichen Motorschutzschaltungen und deren Sollbereichen bekannt sind oder durch einfache Tests sehr schnell ermittelt werden können, wäre es ohne Weiteres möglich, den Elektromotor und/oder die Arbeitsmaschine so anzusteuern, dass die einzelnen Fehlerkriterien gerade noch keinen Alarm auslösen, aber die Summe von wenigstens zwei unterschiedlichen Fehlansteuerungen zu einer Beschädigung des Elektromotors und/oder der damit gekoppelten Arbeitsmaschinen führen können.

Im Gegensatz zu herkömmlichen Virenschutzprogrammen, die durch Virenscanner, Firewalls, Verschlüsselungen und andere Maßnahmen Schadsoftware erkennen und sie am Zugang hindern, geht die vorliegende Erfindung davon aus, das der Elektromotor und/oder die Arbeitsmaschine von einem Schadcode angesteuert wird. Durch das Aufsummieren von Fehlansteuerungen von wenigstens zwei unterschiedlichen Fehlerkriterien kann ein kritischer Zustand auch dann erkannt werden, wenn sich der Elektromotor und/oder die Arbeitsmaschine hinsichtlich eines bestimmten Fehlerkriteriums noch im Sollbereich befindet.

Durch Messung von wenigstens zwei unterschiedlichen, physikalischen Größen oder Parameter am Elektromotor und/oder der Arbeitsmaschine oder deren Ansteuerung werden Zustände erkannt, die leicht zur deren Zerstörung führen können.

Wird der Elektromotor oder die damit gekoppelten Arbeitsmaschinen über ein Netzwerk angesteuert, sollte das Schutzgerät vorzugsweise vom Netzwerk getrennt angeordnet werden, so dass das Erfassen der Fehlansteuerungen gemäß der verschiedenen Fehlerkriterien, das Aufsummieren der Anzahl der Fehlansteuerungen und das Auslösen eines Alarmsignals bzw. das Überführen des Elektromotors in einen vordefinierten Zustand von keiner Schadsoftware beeinflusst werden kann.

Durch die gute Kenntnis von Elektromotoren und den damit gekoppelten Arbeitsmaschinen können die wichtigsten Möglichkeiten, die ein potentieller Angreifer hat, um einen Motor zu zerstören, relativ einfach in Fehlerkriterien beschrieben werden. Diese Fehlerkriterien werden im Schutzgerät hinterlegt und laufend überwacht. Überschreitet die Summe der erfassten Fehlansteuerungen ein vorgegebenes Limit, kann das Schutzgerät den Elektromotor entweder Abschalten oder aber in einen vordefiniert, sicheren Zustand bringen. Ein solcher Zustand kann bei einer Pumpe für Kühlmittel zum Beispiel die maximale Leistung sein. Damit wird zwar unter Umständen mehr Energie als nötig verbraucht, es wird aber auf jeden Fall ausreichend gekühlt.

Die Parameter, die überwacht werden können, gliedern sich zum einen in Parameter, die den Elektromotor und dessen Schutz beschreiben und zum zweiten in Parameter, welche die mit dem Elektromotor gekoppelte Arbeitsmaschine beschreiben. Dabei kann insbesondere wenigstens eines der nachfolgend angeführten Fehlerkriterien des Elektromotors und/oder der Arbeitsmaschine erfasst und berücksichtigt werden: Unzulässige Schalthäufigkeit, unzulässige maximale und/oder minimale Einschaltdauer, unzulässige Änderung der Drehzahl , unzulässige Änderung der Drehrichtung, unzulässig hoher Motorstrom in einer Wicklung des Elektromotors, unzulässige Frequenz des Motorstroms, unzulässige Motorspannung über der Frequenz, unzulässiger Motorstrom über der Frequenz, unzulässige Schwingungen am Elektromotor und/oder der Arbeitsmaschine, fehlerhafte Prozessparameter an der Arbeitsmaschine.

Ein Programmierer von Schadsoftware für einen Frequenzumrichter könnte zwei oder mehrere Fehlerkriterien parallel auswählen, um einen Motor kritisch anzusteuern und zu zerstören. Es ist beispielsweise möglich, abwechselnd den Motorstrom zu hoch einzustellen und die Drehrichtung zu schnell zu wechseln. Ein gezieltes Schädigen des Motors wird aber immer in endlich kurzer Zeit stattfinden. Deswegen wird durch jedes Überschreiten einer dieser Fehlerkriterien ein gemeinsamer Zähler im Schutzmodul erhöht, unabhängig davon, welche Regel überschritten wurde. Wenn innerhalb einer bestimmten Zeiteinheit dieser Zähler einen definierten Grenzwert überschreitet, dann gibt das Schutzgerät ein Alarmsignal aus und/oder schaltet der Elektromotor in den vordefinierten sicheren Zustand. Durch das Aufsummieren wird auch vermieden, dass die Anzahl der Fehlalarme (Warnung vor Manipulation, es liegt aber in Wirklichkeit nur eine "normale" kurzzeitige Überlastung des Motors vor) zu hoch wird.

Weitere Ausgestaltungen der Erfindung werden im Folgenden anhand der Beschreibung eines Ausführungsbeispiels näher erläutert.

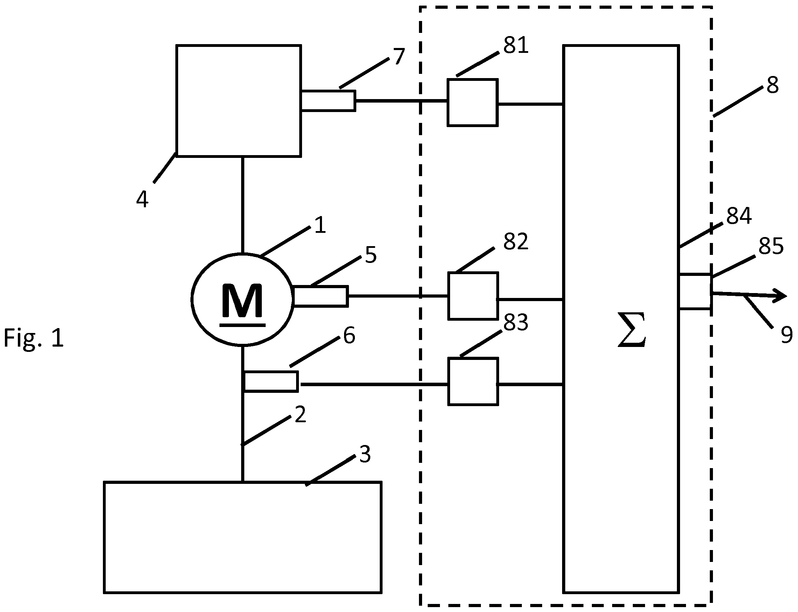

Fig. 1 zeigt ein Blockschaltbild einer Anlage mit Elektromotor, einer damit gekoppelten Arbeitsmaschine und einem Schutzgerät.

Ein Elektromotor 1 ist über eine elektrische Verbindung 2 mit einem Steuergerät 3 (Frequenzumrichter, Regler, SPS oder dergleichen) und mechanisch mit einer Arbeitsmaschine 4 verbunden. Bei der Arbeitsmaschine 4 handelt es sich beispielsweise um einen Verdichter eines Kühlkreislaufs.

Ein Schutzgerät umfasst wenigstens eine erste Erfassungseinheit 5, eine zweite Erfassungseinheit 6 und eine dritte Erfassungseinheit 7, die jeweils Zustandsgrößen des Elektromotors 1, der Ansteuerung des Elektromotors oder der Arbeitsmaschine 4 erfassen, die mit möglichen Schädigungen des Elektromotors oder der Arbeitsmaschine in Verbindung stehen. Folgende Zustandsgrößen können beispielsweise erfasst werden: Schalthäufigkeit des Motors, maximale und/oder minimale Einschaltdauer, Drehzahl, Drehrichtung, Motorstrom in einer Wicklung des Elektromotors, Frequenz des Motorstroms, Motorspannung über der Frequenz, Motorstrom über der Frequenz, Schwingungen am Elektromotor und/oder der Arbeitsmaschine, Prozessparameter an der Arbeitsmaschine. Die Liste ist jedoch keineswegs als abschließend zu betrachten. Je nach Elektromotor oder Arbeitsmaschine können auch weitere oder andere Zustandsgrößen gemessen und ausgewertet werden.

Das Schutzgerät umfasst ferner eine Auswerteelektronik 8, wobei die in den Erfassungseinheiten 5, 6 und 7 gemessenen Zustandsgrößen unter Berücksichtigung eines individuellen Gewichtungsfaktors 81, 82, 83 in einem gemeinsamen Summierglied 84 gemeinsam bewertet und zusammengeführt werden. Dabei werden die gemessenen Zustandsgrößen mit vorgegebenen Sollwerten verglichen. Ist der Sollwert überschritten, wird dies als Fehlansteuerung eingestuft, wobei im Summierglied 84 alle Fehlansteuerungen der Erfassungseinheiten 5, 6 und 7, gegebenenfalls mit einem individuellen Gewichtungsfaktor, aufsummiert werden.

Wird innerhalb eines vordefinierten Zeitraums eine zu hohe Anzahl an Fehlansteuerungen durch die Erfassungseinheiten erfasst, wird über ein Auslösegerät 85 ein Ausgangssignal 9 erzeugt, das auf eine mögliche Manipulation des Steuergeräts 3 hinweist. Bei diesem Ausgangssignal 9 kann es sich um ein Alarmsignal handeln. Mit diesem Ausgangssignal 9 könnte der Elektromotor aber auch in einen vordefinierten Zustand geschaltet werden. Das Aufsummieren der Fehlansteuerungen über einen vordefinierten Zeitraum hat auch den Vorteil, dass nicht schon bei einem einmaligen Überschreiten eines Sollwerts ein Ausgangssignal 9 erzeugt wird.

## Patentansprüche

1. Verfahren zum Schutz eines Elektromotors (1) und/oder einer damit gekoppelten Arbeitsmaschine (4) vor Fehlansteuerungen, wobei die Anzahl von Fehlansteuerungen des Elektromotors (1) und/oder der Arbeitsmaschine (4) gemäß einem ersten Fehlerkriterium und die Anzahl von Fehlansteuerungen des Elektromotors (1) und/oder der Arbeitsmaschine (4) gemäß einem zweiten Fehlerkriterium erfasst und aufsummiert werden, wobei ein Alarmsignal erzeugt und/oder der Elektromotor (1) in einen vordefinierten Zustand geschaltet wird, wenn die Summe der erfassten Fehlansteuerungen ein vorgegebenes Limit überschreitet, **dadurch gekennzeichnet, dass** die Fehlerkriterien bei der Aufsummierung der Fehlansteuerungen unterschiedlich gewichtet werden.

2. Verfahren nach Anspruch 1, **dadurch gekennzeichnet, dass** wenigstens eines der nachfolgend angeführten Fehlerkriterien des Elektromotors (1) und/oder der Arbeitsmaschine erfasst und berücksichtigt wird: Unzulässige Schalthäufigkeit, unzulässige maximale und/oder minimale Einschaltdauer, unzulässige Änderung der Drehzahl , unzulässige Änderung der Drehrichtung, unzulässig hoher Motorstrom in einer Wicklung des Elektromotors, unzulässige Frequenz des Motorstroms, unzulässige Motorspannung über der Frequenz, unzulässiger Motorstrom über der Frequenz, unzulässige Schwingungen am Elektromotor und/oder der Arbeitsmaschine, fehlerhafte Prozessparameter an der Arbeitsmaschine.

3. Verfahren nach einem der vorhergehenden Ansprüche, **dadurch gekennzeichnet, dass** das Alarmsignal nur dann erzeugt und/oder der Elektromotor (1) nur dann in einen vordefinierten Zustand geschaltet wird, wenn die Summe der erfassten Fehlansteuerungen in einem vorgegebenen Zeitintervall ein vorgegebenes Limit überschreitet.

4. Verfahren nach einem der vorhergehenden Ansprüche, **dadurch gekennzeichnet, dass** der Elektromotor (1) über ein Netzwerk angesteuert wird und die Erfassung der Fehlansteuerungen, die Aufsummierung der Anzahl der Fehlansteuerungen und die Erzeugung des Alarmsignals und/oder das Schalten des Elektromotors (1) in den vordefinierten Zustand, wenn die Summe der erfassten Fehlansteuerungen ein vorgegebenes Limit überschreitet, ohne Verbindung zum Netzwerk erfolgt.

5. Schutzgerät zum Schutz eines Elektromotors (1) und/oder einer damit gekoppelten Arbeitsmaschine (4) vor Fehlansteuerungen, mit
- einer ersten Erfassungseinheit (5) für Fehlansteuerungen des Elektromotors und/oder der Arbeitsmaschine gemäß einem ersten Fehlerkriterium,
- wenigstens einer zweiten Erfassungseinheit (6, 7) für Fehlansteuerungen des Elektromotors (1) und/oder der Arbeitsmaschine (4) gemäß einem zweiten Fehlerkriterium,
- einem Summierglied (84) zum Aufsummieren der Anzahl der Fehlansteuerungen mit unterschiedlicher Gewichtung der Fehlerkriterien und
- einer Auslöseeinheit (85) zur Erzeugung eines Alarmsignals und/oder zum Schalten des Elektromotors (1) in einen vordefinierten Zustand, wenn die Summe der erfassten Fehlansteuerungen ein vorgegebenes Limit überschreitet.

6. Schutzgerät nach Anspruch 5, **dadurch gekennzeichnet, dass** der Elektromotor (1) zur Ansteuerung über ein Netzwerk verbunden ist und das Schutzgerät vom Netzwerk getrennt angeordnet ist.

## Claims

1. Method for protection of an electric motor (1) and/or an operating machine (4) which is coupled thereto from incorrect control operations, wherein the number of incorrect control operations of the electric motor (1) and/or the operating machine (4) is detected in accordance with a first error criterion and the number of incorrect control operations of the electric motor (1) and/or the operating machine (4) is detected in accordance with a second error criterion and totalled, wherein an alarm signal is produced and/or the electric motor (1) is switched into a predefined state when the total of the incorrect control operations detected exceeds a predetermined limit, **characterized in that** the error criteria are weighted differently when the incorrect control operations are totalled.

2. Method according to claim 1, **characterised in that** at least one of the error criteria of the electric motor (1) and/or the operating machine set out below is/are detected and taken into account: unauthorised switching frequency, unauthorised maximum and/or minimum switching-on durations, unauthorised change of speed, unauthorised change of the rotation direction, inadmissibly high motor current in a coil of the electric motor, unauthorised frequency of the motor current, unauthorised motor voltage over the frequency, unauthorised motor current over the frequency, unauthorised oscillations in the electric motor and/or the operating machine, erroneous process parameters in the operating machine.

3. Method according to any one of the preceding claims, **characterised in that** the alarm signal is produced and/or the electric motor (1) is switched to a predefined state only when the total of the incorrect control operations detected within a predetermined period of time exceeds a predetermined limit.

4. Method according to any one of the preceding claims, **characterised in that** the electric motor (1) is controlled by means of a network and the detection of the incorrect control operations, the totalling of the number of incorrect control operations and the production of the alarm signal and/or the switching of the electric motor (1) into a predefined state when the total of the incorrect control operations detected exceeds a predetermined limit are carried out without connection to the network.

5. Protection device for protecting an electric motor (1) and/or an operating machine (4) which is coupled thereto from incorrect control operations having
- a first detection unit (5) for incorrect control operations of the electric motor and/or the operating machine in accordance with a first error criterion,
- at least a second detection unit (6, 7) for incorrect control operations of the electric motor (1) and/or the operating machine (4) in accordance with a second error criterion,
- a totalling member (84) for totalling the number of incorrect control operations with different weighing of the error criteria, and
- an actuation unit (85) for producing an alarm signal and/or for switching the electric motor (1) into a predefined state when the total of the incorrect control operations detected exceeds a predetermined limit.

6. Protection device according to claim 5, **characterised in that** the electric motor (1) is connected via a network for control and the protection device is arranged so as to be separated from the network.

## Revendications

1. Procédé pour protéger contre les commandes erronées un moteur électrique (1) et / ou une machine de travail (4) couplée avec celui-ci, sachant que le nombre des commandes erronées du moteur électrique (1) et / ou de la machine de travail (4) correspondant à un premier critère d'erreurs et le nombre des commandes erronées du moteur électrique (1) et / ou de la machine de travail (4) correspondant à un deuxième critère d'erreurs sont détectés et totalisés, un signal d'alarme étant généré et / ou le moteur électrique (1) étant commuté dans un état prédéfini quand la somme des commandes erronées surpasse une limite prédéterminée,
**caractérisé en ce que** les critères d'erreurs sont évalués différemment lors de la totalisation des commandes erronées.

2. Procédé selon la revendication 1, **caractérisé en ce que** au moins l'un des critères d'erreurs du moteur électrique (1) et / ou de la machine de travail, ci-dessous mentionnés, est détecté et pris en compte: fréquence de commutation inadmissible, durée de connexion maximale et / ou minimale inadmissible, changement inadmissible de la vitesse de rotation, changement inadmissible de la direction de rotation, élévation inadmissible du courant du moteur dans le bobinage du moteur, fréquence inadmissible du courant du moteur, tension inadmissible du moteur au-dessus de la fréquence, courant de moteur inadmissible, au-dessus de la fréquence, vibrations inadmissible du moteur électrique (1) et / ou de la machine de travail (4), paramètres de processus erronés de la machine de travail.

3. Procédé selon l'une des revendications précédentes,
**caractérisé en ce que** le signal d'alarme n'est généré et / ou le moteur électrique (1) n'est commuté dans un état prédéterminé que si la somme des commandes erronées, détectées surpasse une limite prédéterminée dans un intervalle de temps prédéterminé.

4. Dispositif selon l'une des revendications précédentes,
**caractérisé en ce que** le moteur électrique (1) est commandé par l'intermédiaire d'un réseau et que la détection des commandes erronées, la totalisation du nombre des commandes erronées et la génération du le signal d'alarme et / ou la commutation du moteur électrique (1) dans un état prédéfini, quand la somme des commandes erronées détectées surpasse une limite prédéterminée, sont effectuées sans liaison au réseau.

5. Appareil pour protéger contre les commandes erronées un moteur électrique (1) et / ou une machine de travail (4) couplée avec celui-ci, avec
- une première unité de détection (5) des commandes erronées du moteur électrique et / ou de la machine de travail correspondant à un premier critère d'erreurs,
- au moins une deuxième unité de détection (6, 7) des commandes erronées du moteur électrique (1) et / ou de la machine de travail (4) correspondant à un deuxième critère d'erreurs,
- un organe de totalisation (84) pour la totalisation du nombre des erreurs de commande avec évaluation différente des critères d'erreurs, et
- une unité de déclenchement (85) pour générer un signal d'alarme et / ou pour commuter le moteur électrique (1) dans un état prédéfini quand la somme des erreurs de commande surpasse une limite prédéterminée.

6. Appareil de protection selon la revendication 5,
**caractérisé en ce que,** pour la commande, le moteur électrique (1) est relié par l'intermédiaire d'un réseau et que l'appareil de protection est installé, séparé du réseau.
